# EUROPEAN PATENT APPLICATION

(11) **EP 4 340 040 A1**
(43) Date of publication of application: **20.03.2024**
(21) Application number: 23153228.4
(22) Date of filing: 25.01.2023
(51) Int. Cl.: H01L 29/78, H01L 29/06, H01L 29/08

(54) **SEMICONDUCTOR DEVICE**

(30) Priority: 15.09.2022 JP 2022147107
(71) Applicant: KABUSHIKI KAISHA TOSHIBA, Minato-ku Tokyo 105-0023 (JP); Toshiba Electronic Devices & Storage Corporation, Tokyo 105-0023 (JP)
(72) Inventor: TANAKA, Katsuhisa, Tokyo, 105-0023 (JP); KONO, Hiroshi, Tokyo, 105-0023 (JP)
(74) Representative: Kramer Barske Schmidtchen Patentanwälte PartG mbB

(57) **Abstract**

A semiconductor device includes a first electrode, a second electrode, a third electrode located between the first electrode and the second electrode, a first semiconductor layer connected to the first electrode, a second semiconductor layer connected to the second electrode, a third semiconductor layer of a second conductivity type, and a fourth semiconductor layer of the second conductivity type. The third electrode includes first and second portions. The first semiconductor layer faces the first portion via an insulating layer. The first and second semiconductor layers are of a first conductivity type and include silicon and carbon. A carrier concentration of the fourth semiconductor layer is greater than a carrier concentration of the third semiconductor layer.

## Description

### FIELD

Embodiments relate to a semiconductor device.

### BACKGROUND

Semiconductor devices that use silicon carbide as a semiconductor material are being developed to improve the balance between the on-resistance and the breakdown voltage of the semiconductor device. It is desirable to suppress breakdown due to the application of high voltages and to improve the operation stability of such a semiconductor device.

### BRIEF DESCRIPTION OF THE DRAWINGS

FIG. 1 is a perspective view showing an upper portion of a semiconductor device according to a first embodiment;
FIG. 2 is a plan view showing the semiconductor device according to the first embodiment;
FIG. 3 is a cross-sectional view along line A-A' shown in FIG. 2;
FIG. 4 is a cross-sectional view along line B-B' shown in FIG. 2;
FIG. 5 is a cross-sectional view along line C-C' shown in FIG. 2;
FIG. 6 is a plan view showing region D of FIG. 2;
FIG. 7 is a plan view showing a boundary vicinity between a cell part and a termination part of the semiconductor device according to the first embodiment;
FIG. 8 is a cross-sectional view showing a semiconductor device according to a comparative example;
FIG. 9 is a plan view showing a semiconductor device according to a second embodiment;
FIG. 10 is a cross-sectional view along line F-F' shown in FIG. 9;
FIG. 11 is a plan view showing a semiconductor device according to a third embodiment;
FIG. 12 is a plan view showing a semiconductor device according to a fourth embodiment; and

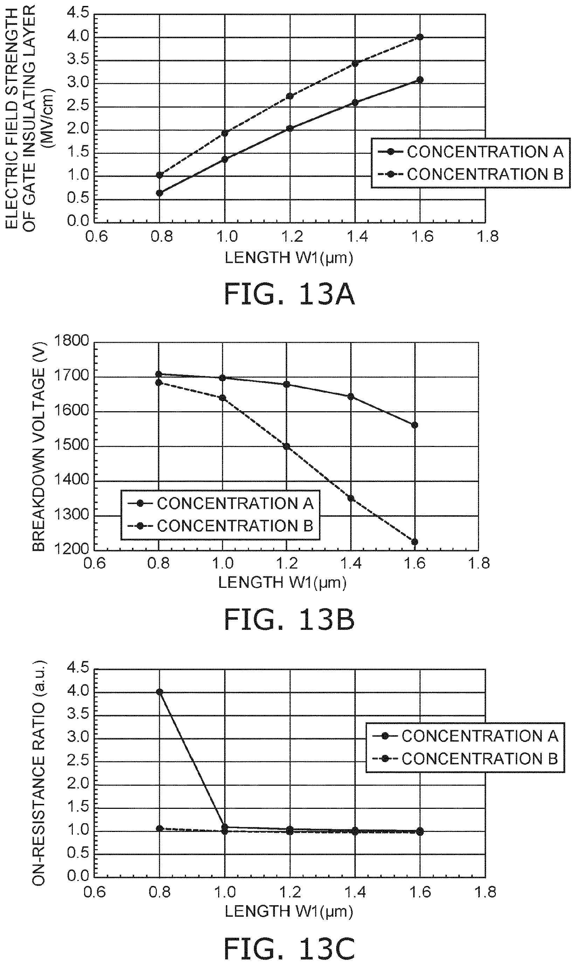

FIG. 13A is a graph showing the effects of the length W1 on the electric field strength, in which the horizontal axis is the length W1, and the vertical axis is the electric field strength applied to the gate insulating layer; FIG. 13B is a graph showing the effects of the length W1 on the breakdown voltage, in which the horizontal axis is the length W1, and the vertical axis is the breakdown voltage; and FIG. 13C is a graph showing the effects of the length W1 on the on-resistance, in which the horizontal axis is the length W1, and the vertical axis is the relative value of the on-resistance.

### DETAILED DESCRIPTION

In general, according to one embodiment, a semiconductor device includes a first electrode, a second electrode, a third electrode located between the first electrode and the second electrode, a first semiconductor layer connected to the first electrode, a second semiconductor layer connected to the second electrode, a third semiconductor layer of a second conductivity type, and a fourth semiconductor layer of the second conductivity type. The third electrode extends in a first direction and includes a first portion and a second portion. The first semiconductor layer faces the first portion via an insulating layer. The first semiconductor layer is of a first conductivity type and includes silicon and carbon. The second semiconductor layer is of the first conductivity type and includes silicon and carbon. At least a portion of the third semiconductor layer is located between the first semiconductor layer and the second semiconductor layer. The third semiconductor layer contacts the first and second semiconductor layers, faces the third electrode via the insulating layer, and includes silicon and carbon. At least a portion of the fourth semiconductor layer is located between the first semiconductor layer and the second portion. The fourth semiconductor layer faces the second portion via the insulating layer. The fourth semiconductor layer contacts the third semiconductor layer and includes silicon and carbon. A carrier concentration of the fourth semiconductor layer is greater than a carrier concentration of the third semiconductor layer.

### First embodiment

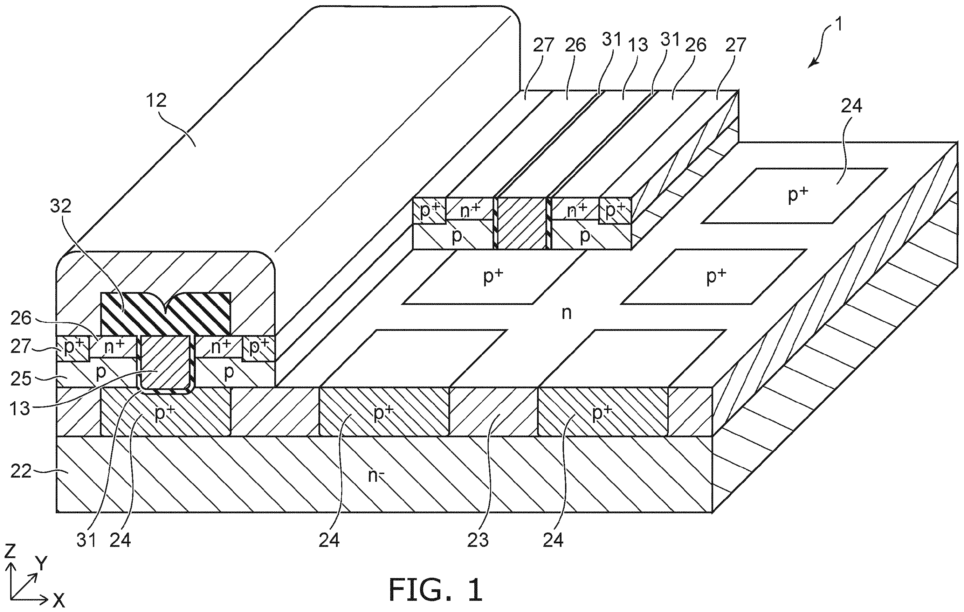

FIG. 1 is a perspective view showing the upper portion of a semiconductor device according to the embodiment.

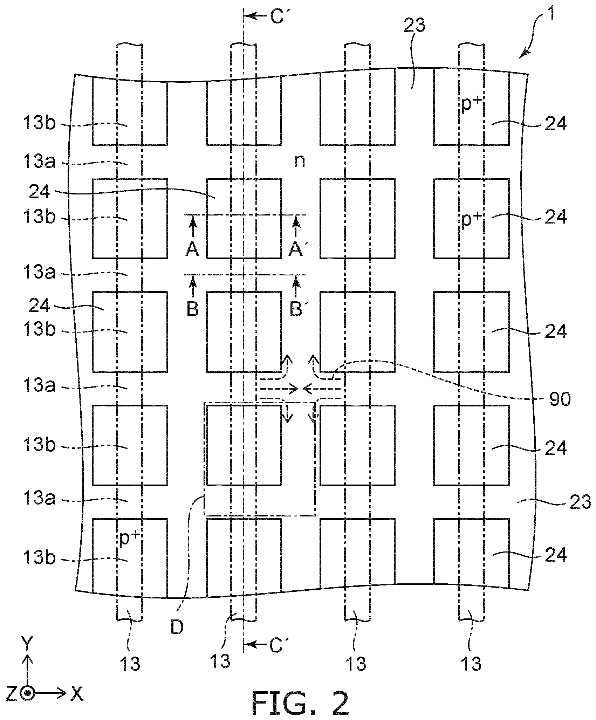

FIG. 2 is a plan view showing the semiconductor device according to the embodiment.

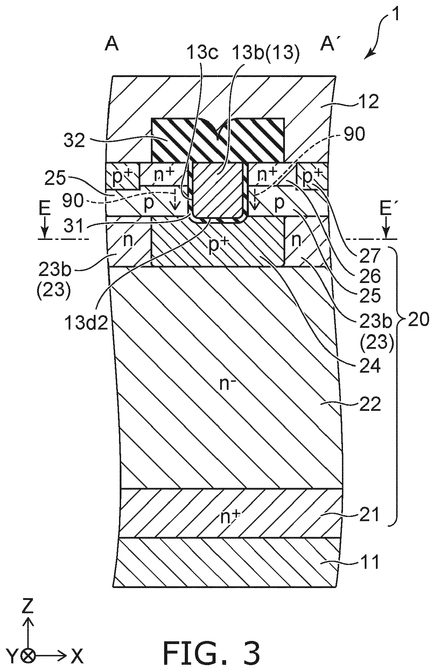

FIG. 3 is a cross-sectional view along line A-A' shown in FIG. 2.

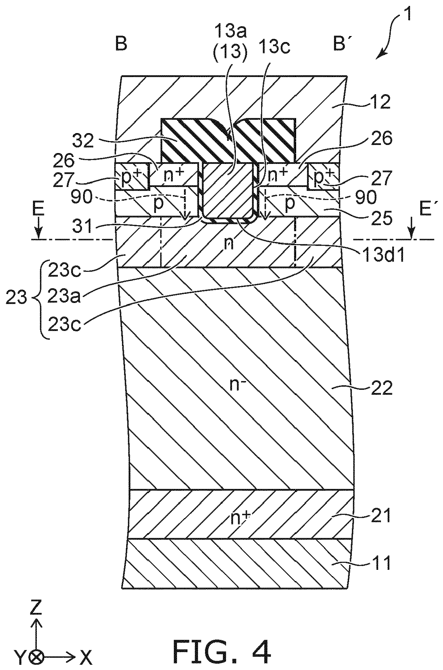

FIG. 4 is a cross-sectional view along line B-B' shown in FIG. 2.

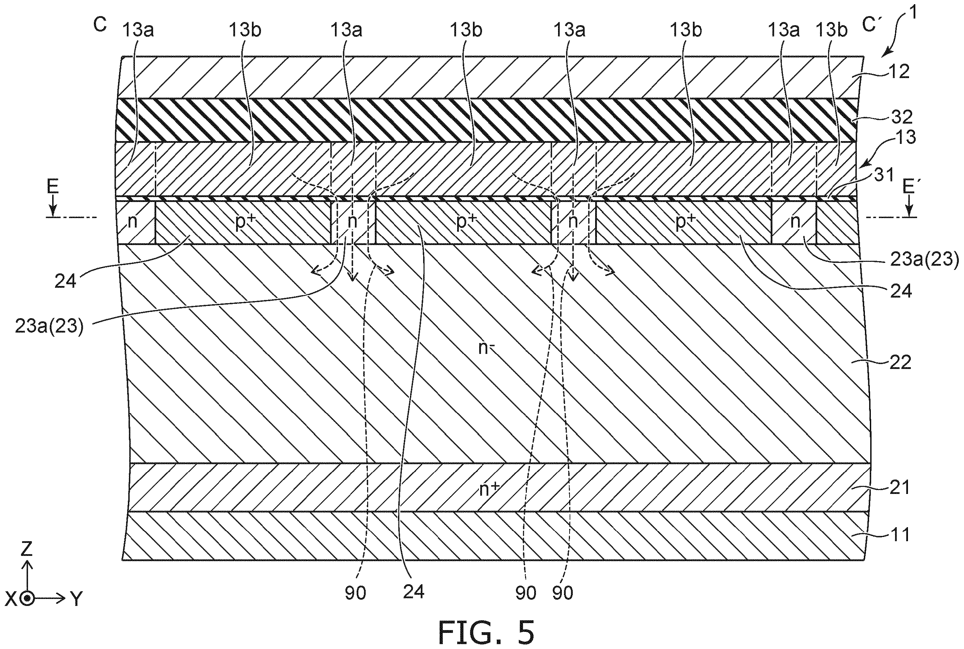

FIG. 5 is a cross-sectional view along line C-C' shown in FIG. 2.

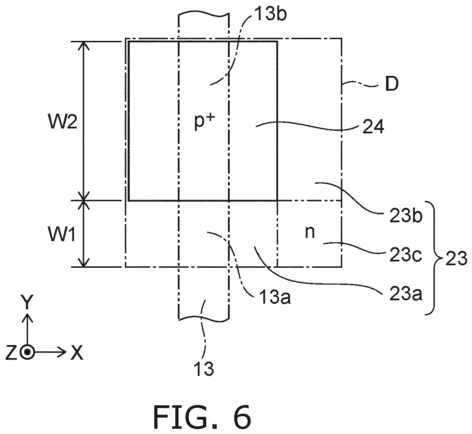

FIG. 6 is a plan view showing region D of FIG. 2.

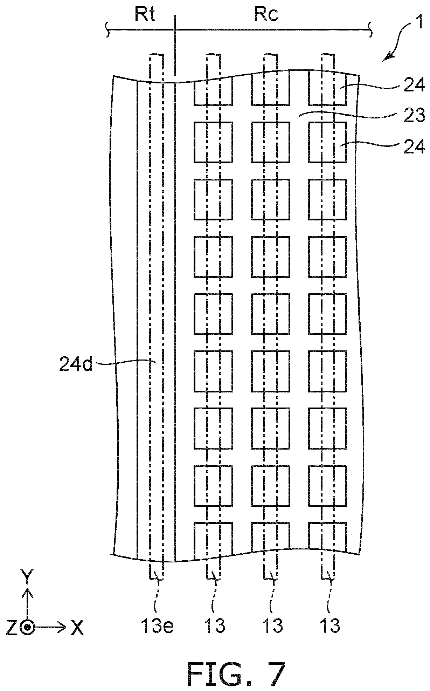

FIG. 7 is a plan view showing a boundary vicinity between a cell part and a termination part of the semiconductor device according to the embodiment.

In FIG. 1, a portion of the configuration of the upper portion is not illustrated to show the internal configuration.

FIG. 2 shows a surface corresponding to line E-E' shown in FIGS. 3 to 5.

The drawings are schematic or conceptual, and are enhanced and simplified as appropriate. The shapes and dimensional ratios of the components do not always match between the drawings. This is similar for the other drawings described below as well.

As shown in FIGS. 1 to 6, the semiconductor device 1 according to the embodiment includes a drain electrode 11, a source electrode 12, multiple gate electrodes 13, a semiconductor part 20, multiple gate insulating layers 31, and multiple inter-electrode insulating films 32. The semiconductor part 20 includes a SiC substrate 21, a drift layer 22, a current spreading layer (current diffusion layer) 23, multiple bottom layers 24, a base layer 25, multiple source layers 26, and multiple contact layers 27. The SiC substrate 21 functions as a drain layer. The portion of the semiconductor part 20 other than the SiC substrate 21 is a SiC epitaxial layer. The semiconductor device 1 is a trench MOSFET (Metal-Oxide-Semiconductor Field-Effect Transistor).

In the specification hereinbelow, an XYZ orthogonal coordinate system is employed for convenience of description. The arrangement direction of the drain electrode 11 and the source electrode 12 is taken as a "Z-direction"; the direction in which the gate electrodes 13 extend is taken as a "Y-direction" (a first direction); and the arrangement direction of the multiple gate electrodes 13 is taken as an "X-direction" (a second direction). Among the Z-directions, a direction that is from the drain electrode 11 toward the source electrode 12 also is called "up", and the opposite direction also is called "down", but these expressions are for convenience and are independent of the direction of gravity.

The drain electrode 11 (a first electrode) is plate-shaped and is provided over the entire or substantially the entire lower surface of the semiconductor device 1. The source electrode 12 (a second electrode) also is plate-shaped, and is located in substantially the entire region of the upper surface of the semiconductor device other than where a gate pad (not illustrated) is located. The drain electrode 11 and the source electrode 12 are made of, for example, a metal material, e.g., aluminum (Al) and titanium (Ti).

A cell region Rc of the semiconductor device 1 will now be described.

The multiple gate electrodes 13 (third electrodes) are located between the drain electrode 11 and the source electrode 12. The multiple gate electrodes 13 are periodically arranged along the X-direction; and each gate electrode 13 extends in the Y-direction. For example, the gate electrodes 13 are formed of polysilicon that includes an impurity. The gate electrodes 13 are connected to a gate pad (not illustrated) at some position in the longitudinal direction (the Y-direction).

The semiconductor part 20 is located between the drain electrode 11 and the source electrode 12. The gate electrode 13 is located in the upper layer portion of the semiconductor part 20. The semiconductor part 20 includes silicon and carbon and is made of, for example, single-crystal silicon carbide (SiC). The conductivity types of the portions of the semiconductor part 20 are defined by locally including impurities.

The conductivity type of the SiC substrate 21 is the n⁺-type. The SiC substrate 21 contacts the drain electrode 11 and is connected to the drain electrode 11. In the specification, "connected" means an electrical connection. The conductivity type of the drift layer 22 is the n⁻-type. The drift layer 22 is located on the SiC substrate 21 and contacts the SiC substrate 21. The conductivity type of the current spreading layer 23 is the n-type. The current spreading layer 23 is located on a portion of the drift layer 22 and contacts the drift layer 22. A first semiconductor layer includes the SiC substrate 21, the drift layer 22, and the current spreading layer 23.

The "n⁺-type" refers to a higher carrier concentration than the "n-type"; and the "n⁻-type" refers to a lower carrier concentration than the "n-type". This is similar for the p-type as well. The "carrier concentration" refers to the effective impurity concentration functioning as a donor or acceptor.

The conductivity type of the bottom layer 24 (a fourth semiconductor layer) is the p⁺-type. The bottom layer 24 contacts the drift layer 22 and is located on the drift layer 22 in a region in which the current spreading layer 23 is not located. In other words, the current spreading layer 23 and the bottom layer 24 are located on the drift layer 22. According to the embodiment as shown in FIG. 2, the multiple bottom layers 24 are arranged in a matrix configuration along the X-direction and the Y-direction. The bottom layers 24 are periodically arranged in both the X-direction and the Y-direction. Each bottom layer 24 is rectangular when viewed along the Z-direction.

The current spreading layer 23 has a lattice shape surrounding the multiple bottom layers 24. As shown in FIG. 6, the current spreading layer 23 includes a portion 23a located between the bottom layers 24 next to each other in the Y-direction, a portion 23b located between the bottom layers 24 next to each other in the X-direction, and a portion 23c located at a diagonal position when viewed from the bottom layer 24. The portion 23c is positioned between the portions 23a next to each other in the X-direction and between the portions 23b next to each other in the Y-direction.

The carrier concentration of the current spreading layer 23 is greater than the carrier concentration of the drift layer 22. In the current spreading layer 23, a carrier concentration C_{23b} of the portion 23b is not less than a carrier concentration C_{23c} of the portion 23c. The carrier concentration C_{23c} of the portion 23c is not less than a carrier concentration C₂₃ₐ of the portion 23a. The carrier concentration C₂₃ₐ of the portion 23a is not less than a carrier concentration C₂₂ of the drift layer 22. Favorably, the carrier concentration C_{23b} of the portion 23b is greater than the carrier concentration C₂₃ₐ of the portion 23a. In other words, *C_{23b}* ≥ *C_{23c}* ≥ C₂₃ₐ ≥ C*₂₂*, and favorably, *C_{23b}* > *C₂₃ₐ.*

The conductivity type of the base layer 25 (a third semiconductor layer) is the p-type. The carrier concentration of the p⁺-type bottom layer 24 is greater than the carrier concentration of the p-type base layer 25. The base layer 25 is located on the current spreading layer 23 and on the bottom layer 24 and contacts the current spreading layer 23 and the bottom layer 24. More specifically, the upper surface of the bottom layer 24 contacts the lower surface of the base layer 25.

The conductivity type of the source layer 26 (a second semiconductor layer) is the n⁺-type. The conductivity type of the contact layer 27 is the p⁺-type. The source layer 26 and the contact layer 27 are located on the base layer 25 and contact the base layer 25. Accordingly, a portion of the base layer 25 is located between the current spreading layer 23 and the source layer 26. The source layer 26 and the contact layer 27 extend along the Y-direction. The source layer 26 and the contact layer 27 also may contact each other. The source layer 26 and the contact layer 27 contact the source electrode 12 and are connected to the source electrode 12.

For example, the gate insulating layer 31 is formed of silicon oxide (SiO). The gate electrode 13 is insulated from the semiconductor part 20 by the gate insulating layer 31 covering the side surface and the lower surface of the gate electrode 13. In the semiconductor part 20, the upper surface of the current spreading layer 23, the upper surface of the bottom layer 24, the side surface of the base layer 25, and the side surface of the source layer 26 contact the gate insulating layer 31. On the other hand, the SiC substrate 21 and the contact layer 27 are separated from the gate insulating layer 31. The drift layer 22 can be said to be isolated from the gate insulating layer 31 when the carrier concentration C₂₃ₐ of the portion 23a is greater than the carrier concentration C₂₂ of the drift layer 22. On the other hand, the drift layer 22 can be said to partially contact the gate insulating layer 31 when the concentration C₂₂ and the concentration C₂₃ₐ are equal.

For example, the inter-electrode insulating film 32 is formed of silicon oxide. The multiple inter-electrode insulating films 32 are arranged along the X-direction on the semiconductor part 20; and each inter-electrode insulating film 32 extends in the Y-direction. Each inter-electrode insulating film 32 is located in the region directly above the gate electrode 13 and in the two regions at the X-direction sides of the region directly above the gate electrode 13, contacts the gate electrode 13 and the source layer 26, and is separated from the contact layer 27. Thereby, the inter-electrode insulating film 32 insulates the gate electrode 13 from the source electrode 12.

In each gate electrode 13, a first portion 13a and a second portion 13b are alternately arranged along the Y-direction. For example, each gate electrode 13 is formed to have a continuous body; and no interface between the first portion 13a and the second portion 13b is observed. For example, the first portion 13a and the second portion 13b are periodically arranged. In an example, a length W1 of the first portion 13a in the Y-direction is equal to or less than a length W2 of the second portion 13b in the Y-direction. In other words, *W1* ≤ *W2*.

The upper portions of side surfaces 13c of the gate electrode 13 at the two X-direction sides of the gate electrode 13 face the source layer 26 via the gate insulating layer 31 over the full length in the Y-direction. The lower portions of the side surfaces 13c face the base layer 25 via the gate insulating layer 31 over the full length in the Y-direction.

The lower end of the gate electrode 13 slightly penetrates into the current spreading layer 23 and into the bottom layer 24. As shown in FIG. 4, a lower surface 13d1 of the first portion 13a of the gate electrode 13 faces the portion 23a of the current spreading layer 23 via the gate insulating layer 31. In other words, the portion 23a of the current spreading layer 23 is located between the drift layer 22 and the first portion 13a of the gate electrode 13. On the other hand, as shown in FIG. 3, a lower surface 13d2 of the second portion 13b of the gate electrode 13 faces the bottom layer 24 via the gate insulating layer 31. In other words, the bottom layer 24 is located between the drift layer 22 and the second portion 13b of the gate electrode 13. Thus, in the gate electrode 13, the first portion 13a that faces the n-type current spreading layer 23 and the second portion 13b that faces the p⁺-type bottom layer 24 are alternately arranged in the Y-direction.

In the semiconductor device 1 as shown in FIG. 7, a termination region Rt is set at the periphery of the cell region Rc. At the boundary part of the cell region Rc and the termination region Rt, a dummy gate electrode 13e is located and extends in the Y-direction. The dummy gate electrodes 13e are located at the two X-direction sides of the multiple gate electrodes 13 located in the cell region Rc. The gate insulating layer 31 is located on the side surface and on the lower surface of the dummy gate electrode 13e. A bottom layer 24d is located in the region directly under the dummy gate electrode 13e over the full length in the Y-direction. The bottom layer 24d continuously extends along the Y-direction. Therefore, the dummy gate electrode 13e does not face the current spreading layer 23.

Operations of the semiconductor device 1 according to the embodiment will now be described.

A voltage that causes the drain electrode 11 to be positive and the source electrode 12 to be negative is applied between the drain electrode 11 and the source electrode 12. Thereby, a depletion layer is formed with the interface between an n-type semiconductor layer and a p-type semiconductor layer as a starting point; and the semiconductor device 1 is set to the off-state. The n-type semiconductor layer includes the drift layer 22 and the current spreading layer 23. The p-type semiconductor layer includes the base layer 25 and the bottom layer 24. By providing the p⁺-type bottom layer 24 that contacts the gate insulating layer 31 in the region directly under the gate electrode 13, the voltage that is applied to the gate insulating layer 31 can be suppressed at this time.

When a potential that is not less than a threshold is applied to the gate electrode 13 in this state, an inversion layer is formed in the portion of the base layer 25 that contacts the gate insulating layer 31; and an electron current 90 flows. As shown in FIG. 5, the electron current 90 flows in the current spreading layer 23 by detouring around the bottom layer 24 in the Y-direction. In other words, the electron current 90 flows in the order of the source electrode 12, the source layer 26, the inversion layer of the base layer 25, the current spreading layer 23, the drift layer 22, the SiC substrate 21, and the drain electrode 11. Thereby, the semiconductor device 1 is switched to the on-state.

The potential of the base layer 25 is substantially the source potential because the base layer 25 is connected to the source electrode 12 via the contact layer 27. The potential of the bottom layer 24 also is substantially the source potential because the bottom layer 24 is connected to the base layer 25. Because the bottom layer 24 contacts the base layer 25, the resistance between the bottom layer 24 and the base layer 25 is low. Therefore, the potential of the bottom layer 24 is stabilized even when the semiconductor device 1 is switched at high speed. As a result, the operations of the semiconductor device 1 are stabilized.

Because the bottom layer 24 is connected to the base layer 25 with low resistance, the holes can be quickly discharged to the source electrode 12 via the bottom layer 24, the base layer 25, and the contact layer 27 when the semiconductor device 1 is switched from the on-state to the off-state. This also stabilizes the operations of the semiconductor device 1.

Effects of the embodiment will now be described.

In the semiconductor device 1 according to the embodiment, the p⁺-type bottom layer 24 that contacts the gate insulating layer 31 is located in the region directly under the gate electrode 13. Therefore, the application of an excessive voltage to the gate insulating layer 31 in the off-state of the semiconductor device 1 can be suppressed, and the gate insulating layer 31 can be protected. The reliability of the semiconductor device 1 is increased thereby.

Also, the source potential can be efficiently conducted to the bottom layer 24 because the bottom layer 24 contacts the base layer 25 that is located directly above the bottom layer 24. Thereby, even when the semiconductor device 1 is repeatedly switched on/off at high speed, the potential of the bottom layer 24 can be stabilized near the source potential. As a result, the stability of the operations of the semiconductor device 1 is increased. Problems that may occur when the potential of the bottom layer 24 cannot be stably set near the source potential are described below using a comparative example.

The current path from the base layer 25 to the drift layer 22 can be ensured by providing the bottom layer 24 discontinuously without being in the entire region directly under the gate electrode 13 and by providing the current spreading layer 23 between the bottom layers 24. The operations of the MOSFET can be stably realized thereby.

The on-resistance can be reduced by setting the carrier concentration of the current spreading layer 23 to be greater than the carrier concentration of the drift layer 22. In particular, by setting the carrier concentration C_{23b} of the portion 23b of the current spreading layer 23 to be not less than the carrier concentration C_{23c} of the portion 23c and by setting the carrier concentration C_{23c} of the portion 23c to be not less than the carrier concentration C₂₃ₐ of the portion 23a, the electron current 90 can be effectively diffused in the Y-direction, and the drift layer 22 can be effectively utilized as the current path. This also can reduce the on-resistance.

### Comparative example

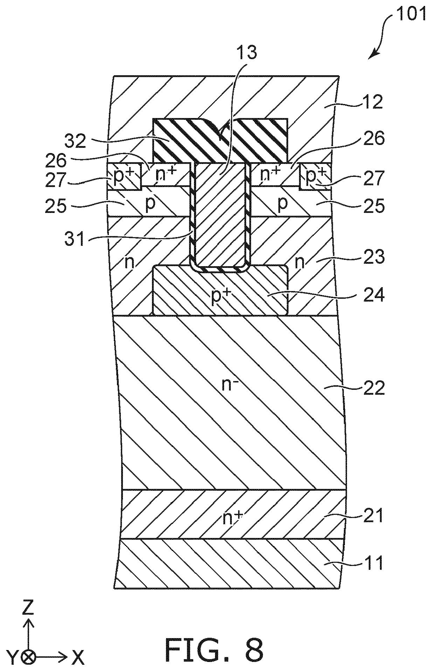

FIG. 8 is a cross-sectional view showing a semiconductor device according to a comparative example.

FIG. 8 is a cross section corresponding to FIG. 3 of the first embodiment.

In the semiconductor device 101 according to the comparative example as shown in FIG. 8, the bottom layer 24 is separated from the base layer 25. Also, the bottom layer 24 is continuously located in the Y-direction. In other words, the bottom layer 24 is located in the entire region directly under the gate electrode 13.

In the comparative example, the potential of the bottom layer 24 is unstable because the bottom layer 24 is separated from the base layer 25. Even if the bottom layer 24 is connected to the base layer 25 at some position in the longitudinal direction (the Y-direction), the internal resistance along the Y-direction of the bottom layer 24 makes it difficult for the source potential to be conducted over the entire bottom layer 24. Therefore, the potential of the bottom layer 24 undesirably fluctuates locally when the semiconductor device 101 is repeatedly switched on/off at high speed. As a result, the operations of the semiconductor device 101 become unstable.

The dielectric breakdown electric field of the silicon oxide (SiO) forming the gate insulating layer 31 is less than the dielectric breakdown electric field of the silicon carbide (SiC) forming the semiconductor part 20; therefore, unless the bottom layer 24 is located below the gate electrode 13, there is a possibility that breakdown of the gate insulating layer 31 may be caused by an excessive voltage applied to the gate insulating layer 31 in the off-state. As a result, the reliability of the semiconductor device degrades. If, conversely, the source-drain voltage is suppressed to be low enough to avoid breakdown of the gate insulating layer 31 even when the bottom layer 24 is not included, the full characteristics of a semiconductor device using silicon carbide will not be sufficiently realized. Or, if the bottom layer 24 is elongated upward from the state shown in FIG. 8 to contact the base layer 25, the electron current that flows through the source layer 26 and the inversion layer of the base layer 25 does not easily flow into the drift layer 22; and the on-resistance is markedly increased.

### Second embodiment

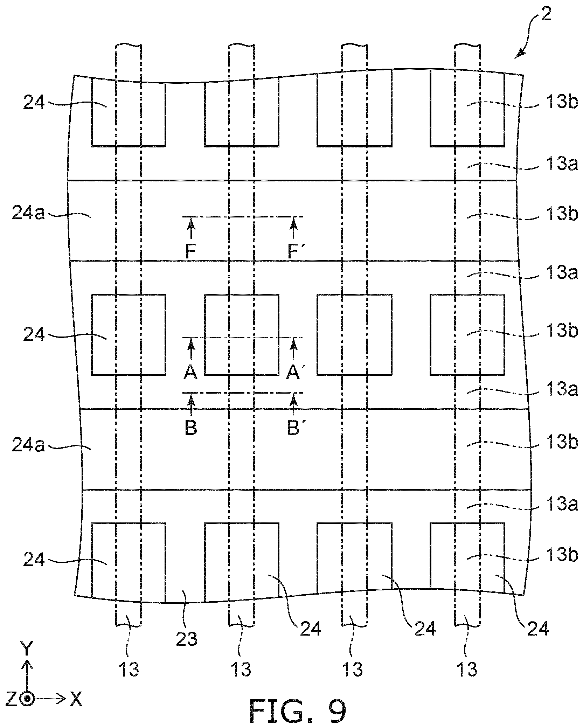

FIG. 9 is a plan view showing a semiconductor device according to the embodiment.

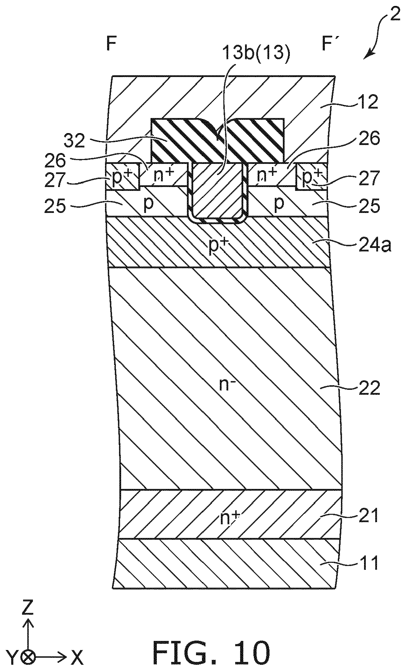

FIG. 10 is a cross-sectional view along line F-F' shown in FIG. 9.

The cross-sectional view along line A-A' shown in FIG. 9 is similar to FIG. 3; and the cross-sectional view along line B-B' is similar to FIG. 4.

In the semiconductor device 2 according to the embodiment as shown in FIGS. 9 and 10, some of the multiple bottom layers 24 extend in band shapes along the X-direction and extend over the regions directly under the second portions 13b of the multiple gate electrodes 13 arranged along the X-direction. In the example shown in FIG. 9, a column that includes the multiple bottom layers 24 arranged in one column along the X-direction is alternately arranged in the Y-direction with one band-shaped bottom layer 24a extending in the X-direction.

According to the embodiment, when a higher voltage than normal is applied between the drain electrode 11 and the source electrode 12 due to, for example, a short-circuit of a load connected to the semiconductor device 2, etc., the portion 23a of the current spreading layer (current diffusion layer) 23 is depleted, and the portions 23b and 23c of the current spreading layer 23 (see FIG. 6) become the major path of the current. The peak current value flowing in the semiconductor device 2 can be suppressed thereby. As a result, the reliability of the semiconductor device 2 is increased. Otherwise, the configuration, operations, and effects of the embodiment are similar to those of the first embodiment.

### Third embodiment

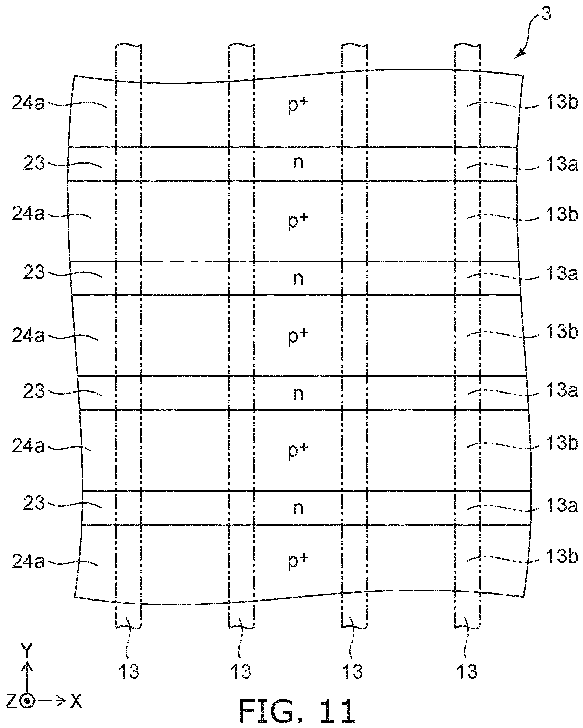

FIG. 11 is a plan view showing a semiconductor device according to the embodiment.

In the semiconductor device 3 according to the embodiment as shown in FIG. 11, all of the bottom layers 24a have band shapes extending in the X-direction. The effects of the second embodiment can be more reliably obtained thereby. Otherwise, the configuration, operations, and effects of the embodiment are similar to those of the first embodiment.

### Fourth embodiment

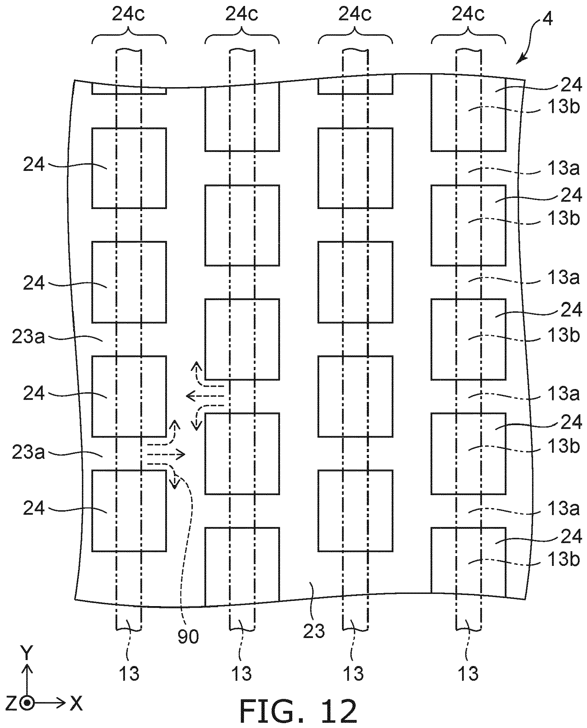

FIG. 12 is a plan view showing a semiconductor device according to the embodiment.

In the semiconductor device 4 according to the embodiment as shown in FIG. 12, a column 24c is configured by periodically arranging the multiple bottom layers 24 in one column along the Y-direction. Multiple columns 24c are periodically arranged along the X-direction. The Y-direction positions of the bottom layers 24 are different between the columns 24c next to each other in the X-direction. In other words, the multiple bottom layers 24 when viewed along the Z-direction are arranged in a staggered configuration.

According to the embodiment, the positions of the portions 23a of the current spreading layer (current diffusion layer) 23 can be shifted by shifting the positions of the bottom layers 24 between the columns 24c that are next to each other. The electron current 90 of the current spreading layer 23 can be uniformly distributed, and the on-resistance can be reduced thereby. Also, the degradation of the current spreading layer 23 and the drift layer 22 due to current concentration can be suppressed. Otherwise, the configuration, operations, and effects of the embodiment are similar to those of the first embodiment.

### Test examples

For test examples, the effects of the length W1 in the Y-direction of the first portion 13a of the gate electrode 13 (see FIG. 6) on the characteristics of the semiconductor device was investigated by simulation. Specifically, assuming the semiconductor device according to the first embodiment, the on-resistance, the breakdown voltage, and the electric field strength applied to the gate insulating layer 31 located on the lower surface of the gate electrode 13 were calculated for multiple conditions having different lengths W1. Two types of states having different carrier concentrations of the current spreading layer 23 were calculated for each value of the length W1.

FIG. 13A is a graph showing the effects of the length W1 on the electric field strength, in which the horizontal axis is the length W1, and the vertical axis is the electric field strength applied to the gate insulating layer; FIG. 13B is a graph showing the effects of the length W1 on the breakdown voltage, in which the horizontal axis is the length W1, and the vertical axis is the breakdown voltage; and FIG. 13C is a graph showing the effects of the length W1 on the on-resistance, in which the horizontal axis is the length W1, and the vertical axis is the relative value of the on-resistance. The "concentration A" is less than the "concentration B" in FIGS. 13A to 13C.

As shown in FIG. 13A, the electric field strength that was applied to the gate insulating layer 31 located on the lower surface of the gate electrode 13 increased as the length W1 increased. Therefore, as shown in FIG. 13B, the breakdown voltage of the semiconductor device decreased as the length W1 increased. As shown in FIG. 13C, the on-resistance substantially does not change when the length W1 was not less than 1 µm.

According to the embodiments described above, a semiconductor device can be realized in which breakdown can be suppressed and stability of the operations can be improved.

Although an example is shown in the embodiments described above in which the first and second portions 13a and 13b of the gate electrode 13 are periodically arranged along the longitudinal direction of the gate electrode 13 (the Y-direction), the arrangement is not limited thereto. For example, the arrangement of the first and second portions 13a and 13b may not be periodic. The first portion 13a and the second portion 13b may be arranged along the width direction of the gate electrode 13 (the X-direction).

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Embodiments include the following aspects.

### Note 1

A semiconductor device, comprising:
a first electrode;
a second electrode;
a third electrode located between the first electrode and the second electrode, the third electrode extending in a first direction and including a first portion and a second portion;
a first semiconductor layer connected to the first electrode, the first semiconductor layer facing the first portion via an insulating layer, the first semiconductor layer being of a first conductivity type and including silicon and carbon;
a second semiconductor layer connected to the second electrode, the second semiconductor layer being of the first conductivity type and including silicon and carbon;
a third semiconductor layer of a second conductivity type, at least a portion of the third semiconductor layer being located between the first semiconductor layer and the second semiconductor layer, the third semiconductor layer contacting the first and second semiconductor layers, facing the third electrode via the insulating layer, and including silicon and carbon; and
a fourth semiconductor layer of the second conductivity type, at least a portion of the fourth semiconductor layer being located between the first semiconductor layer and the second portion, the fourth semiconductor layer facing the second portion via the insulating layer, the fourth semiconductor layer contacting the third semiconductor layer and including silicon and carbon, a carrier concentration of the fourth semiconductor layer being greater than a carrier concentration of the third semiconductor layer.

### Note 2

The device according to note 1, wherein
a surface of the fourth semiconductor layer at the second electrode side contacts the third semiconductor layer and the insulating layer.

### Note 3

The device according to note 1 or 2, wherein
a surface of the first semiconductor layer faces the first portion contacts the insulating layer.

### Note 4

The device according to any one of notes 1 to 3, wherein
a length in the first direction of the first portion is not more than a length in the first direction of the second portion.

### Note 5

The device according to any one of notes 1 to 4, wherein
the first portion and the second portion of the third electrode are alternately arranged along the first direction.

### Note 6

The device according to note 5, wherein
the first portion and the second portion are periodically arranged.

### Note 7

The device according to any one of notes 1 to 6, wherein
the second semiconductor layer extends in the first direction and faces the third electrode via the insulating layer.

### Note 8

The device according to any one of notes 1 to 7, wherein
a plurality of the third electrodes is arranged along a second direction crossing the first direction, and
a plurality of the fourth semiconductor layers is arranged along the first direction.

### Note 9

The device according to note 8, wherein
the fourth semiconductor layers are arranged in a matrix configuration along the first and second directions.

### Note 10

The device according to note 8, wherein
a portion of the plurality of fourth semiconductor layers extends across regions directly under the second portions of a plurality of the third electrodes arranged along the second direction.

### Note 11

The device according to note 8, wherein
the plurality of fourth semiconductor layers extends in the second direction and is located in regions directly under the plurality of third electrodes.

### Note 12

The device according to note 8, wherein
columns each include a plurality of the fourth semiconductor layers arranged in one column along the first direction, and
positions in the first direction of the fourth semiconductor layers included in the columns are different between the columns next to each other in the second direction.

### Note 13

The device according to note 9 or 12, wherein
a carrier concentration of a portion of the first semiconductor layer located between the fourth semiconductor layers next to each other in the second direction is greater than a carrier concentration of a portion of the first semiconductor layer located between the fourth semiconductor layers next to each other in the first direction.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device, comprising:
a first electrode (11);
a second electrode (12);
a third electrode (13) located between the first electrode and the second electrode, the third electrode extending in a first direction (Y) and including a first portion (13a) and a second portion (13b);
a first semiconductor layer (21+22+23) connected to the first electrode, the first semiconductor layer facing the first portion via an insulating layer (31), the first semiconductor layer being of a first conductivity type (n) and including silicon and carbon;
a second semiconductor layer (26) connected to the second electrode, the second semiconductor layer being of the first conductivity type and including silicon and carbon;
a third semiconductor layer (25) of a second conductivity type (p), at least a portion of the third semiconductor layer being located between the first semiconductor layer and the second semiconductor layer, the third semiconductor layer contacting the first and second semiconductor layers, facing the third electrode via the insulating layer, and including silicon and carbon; and
a fourth semiconductor layer (24) of the second conductivity type, at least a portion of the fourth semiconductor layer being located between the first semiconductor layer and the second portion, the fourth semiconductor layer facing the second portion via the insulating layer, the fourth semiconductor layer contacting the third semiconductor layer and including silicon and carbon, a carrier concentration of the fourth semiconductor layer being greater than a carrier concentration of the third semiconductor layer.

2. The device according to claim 1, wherein
a surface of the fourth semiconductor layer at the second electrode side contacts the third semiconductor layer and the insulating layer.

3. The device according to claim 1 or 2, wherein
a surface of the first semiconductor layer faces the first portion contacts the insulating layer.

4. The device according to any one of claims 1 to 3, wherein
a length (W1) in the first direction of the first portion is not more than a length (W2) in the first direction of the second portion.

5. The device according to any one of claims 1 to 4, wherein
the first portion and the second portion of the third electrode are alternately arranged along the first direction.

6. The device according to claim 5, wherein
the first portion and the second portion are periodically arranged.

7. The device according to any one of claims 1 to 6, wherein
the second semiconductor layer extends in the first direction and faces the third electrode via the insulating layer.

8. The device according to any one of claims 1 to 7, wherein
a plurality of the third electrodes is arranged along a second direction (X) crossing the first direction, and
a plurality of the fourth semiconductor layers is arranged along the first direction.

9. The device according to claim 8, wherein
the fourth semiconductor layers are arranged in a matrix configuration along the first and second directions.

10. The device according to claim 8, wherein
a portion of the plurality of fourth semiconductor layers extends across regions directly under the second portions of a plurality of the third electrodes arranged along the second direction.

11. The device according to claim 8, wherein
the plurality of fourth semiconductor layers extends in the second direction and is located in regions directly under the plurality of third electrodes.

12. The device according to claim 8, wherein
columns (24c) each include a plurality of the fourth semiconductor layers arranged in one column along the first direction, and
positions in the first direction of the fourth semiconductor layers included in the columns are different between the columns next to each other in the second direction.

13. The device according to claim 9 or 12, wherein
a carrier concentration of a portion (23b) of the first semiconductor layer located between the fourth semiconductor layers next to each other in the second direction is greater than a carrier concentration of a portion (23a) of the first semiconductor layer located between the fourth semiconductor layers next to each other in the first direction.
